# EUROPEAN PATENT APPLICATION

(11) **EP 2 634 816 A1**
(43) Date of publication of application: **04.09.2013**
(21) Application number: 12001314.9
(22) Date of filing: 28.02.2012
(51) Int. Cl.: H01L 31/0288, H01L 31/068

(54) **Solar battery cell and method of manufacturing the same**

(71) Applicant: PVG Solutions Inc., Kohoku-ku Yokohama-shi Kanagawa 222-0033 (JP)
(72) Inventor: Kano, Yasuyuki, Yokohama-shi Kanagawa 222-0033 (JP); Sugibuchi, Koichi, Yokohama-shi Kanagawa 222-0033 (JP); Goda, Shinji, Yokohama-shi Kanagawa 222-0033 (JP); Ishikawa, Naoki, Yokohama-shi Kanagawa 222-0033 (JP)
(74) Representative: Samson & Partner

(57) **Abstract**

[Problem] To provide a large solar battery cell capable of realizing sufficient conversion efficiency and a method of manufacturing the same.

[Solution] There is provided a solar battery cell (A) including: a p-type diffusion layer and an n-type diffusion layer formed on one surface and another surface of a silicon single crystal substrate; one electrode (45) or more formed on part of the p-type diffusion layer; and one electrode (45) or more formed on part of the n-type diffusion layer, wherein: a plurality of high-concentration p-type diffusion regions (15) and low-concentration p-type diffusion regions (16) each located between the high-concentration p-type diffusion regions are formed in the p-type diffusion layer; a plurality of high-concentration n-type diffusion regions (25) and low-concentration n-type diffusion regions (26) each located between the high-concentration n-type diffusion regions are formed in the n-type diffusion layer.

## Description

### [Technical Field]

The present invention relates to a solar battery cell and a method of manufacturing the same.

### [Background Art]

Solar battery cells are semiconductor elements converting light energy to electric power and include a p-n junction type, a pin type, a Schottky type, and so on, among which the p-n junction type is especially in wide use. Further, if solar batteries are classified based on a substrate material, they are roughly classified into three kinds, that is, a silicon crystal-based solar battery, an amorphous silicon-based solar battery, and a compound semiconductor-based solar battery. The silicon crystal-based solar battery is further classified into a single crystal solar battery and a polycrystalline solar battery. Since a silicon crystal substrate for solar batteries can be relatively easily manufactured, the silicon crystal solar battery is most widely used.

A demand for solar batteries have recently been increased as a clean energy source, and accordingly, a demand for solar battery cells has also been increased. Further, in view of energy efficiency, it is desired that solar battery cells have as high conversion efficiency from light energy to electric power (hereinafter, also simply referred to as conversion efficiency) as possible. Further, for the efficient conversion to electric power, the upsizing of the solar batteries is desired, and the upsizing of the solar batteries also necessitates the upsizing of solar battery cells.

Non-patent documents 1, 2 disclose a solar battery cell with a 1 cm square dimension using a p-type silicon single crystal substrate, whose conversion efficiency is 21.3% on a front surface and 19.8% on a rear surface, and disclose a solar battery cell with a 125 square dimension using a p-type silicon single crystal substrate, whose conversion efficiency is 16.3% on a front surface and 15.0% on a rear surface.

### [Prior Art Document]

### [Non-patent Document]

[Non-patent Document 1] Hitachi Ltd. News Release, April 28, 2000, "Development of Manufacturing Technique of Applied New-Structure Thin Film Solar Cell" consigned through PVTEC (Photovoltaic Power Generation Technology Research Association) by NEDO (New Energy and Industrial Technology Development Organization)
[Non-patent Document 2] NEWS LETTER POWER & ENERGY SYSTEM, No. 35, November, 2007, The Japan Society of Mechanical Engineers

### [Disclosure of the Invention]

### [Problems to Be Solved by the Invention]

However, the solar battery cell described in the aforesaid non-patent document 1 has a problem that in order to achieve the conversion efficiency of 21.3% on the front surface and 19.8% on the rear surface, only a small solar battery cell of, for example, about 1 cm x 1 cm can be manufactured, and there has been such a circumstance that in a large solar battery cell with, for example, about 12.5 cm x 1.2 cm, conversion efficiency can be improved only to 16.3% on the front surface and 15.0% on the rear surface (see the aforesaid non-patent document 1).

In consideration of the above-described circumstances, it is an object of the present invention to provide a large solar battery cell capable of realizing sufficient conversion efficiency and a method of manufacturing the same.

### [Means for Solving the Problems]

In order to attain the aforesaid object, according to the present invention, there is provided a solar battery cell including: an n-type silicon single crystal substrate; a p-type diffusion layer formed on one surface of the silicon single crystal substrate; an n-type diffusion layer formed on another surface of the silicon single crystal substrate; one light-receiving surface grid electrode or more and one busbar electrode or more which are formed on part of the p-type diffusion layer; one light-receiving surface grid electrode or more and one busbar electrode or more which are formed on part of the n-type diffusion layer, wherein a plurality of high-concentration p-type diffusion regions and low-concentration p-type diffusion regions each located between the high-concentration p-type diffusion regions are formed in the p-type diffusion layer, wherein a plurality of high-concentration n-type diffusion regions and low-concentration n-type diffusion regions each located between the high-concentration n-type diffusion regions are formed in the n-type diffusion layer, wherein the light-receiving surface grid electrodes and the busbar electrodes are formed adjacently to the high-concentration p-type diffusion regions and the high-concentration n-type diffusion regions, wherein surface power generation capacity is 18% or more in terms of conversion efficiency, and wherein conversion efficiency of the other surface on which the n-type diffusion layer is formed is equal to or higher than 93% of conversion efficiency of the one surface on which the p-type diffusion layer is formed.

Further, according to the present invention, there is provided a solar battery cell including: an n-type silicon single crystal substrate; a p-type diffusion layer formed on one surface of the silicon single crystal substrate; an entirely uniform n-type diffusion layer formed on another surface of the silicon single crystal substrate; one light-receiving surface grid electrode or more and one busbar electrode or more which are formed on part of the p-type diffusion layer; one light-receiving surface grid electrode or more and one busbar electrode or more which are formed on part of the n-type diffusion layer, wherein a plurality of high-concentration p-type diffusion regions and low-concentration p-type diffusion regions each located between the high-concentration p-type diffusion regions are formed in the p-type diffusion layer, wherein the light-receiving surface grid electrodes and the busbar electrodes are formed adjacently to the high-concentration p-type diffusion regions and the entirely uniform n-type diffusion layer, wherein surface power generation capacity is 18% or more in terms of conversion efficiency, and wherein conversion efficiency of the other surface on which the n-type diffusion layer is formed is equal to or higher than 93% of conversion efficiency of the one surface on which the p-type diffusion layer is formed.

Further, in the above-described solar battery cell, specific resistance of the silicon single crystal substrate may be 1 to 14 Ω●cm. The high-concentration p-type diffusion regions and the low-concentration p-type diffusion regions may be formed by boron diffusion, sheet resistance of the high-concentration p-type diffusion regions may be 20 to 100 Ω/□, and sheet resistance of the low-concentration p-type diffusion regions may be 30 to 150 Ω/□. The high-concentration n-type diffusion regions and the low-concentration n-type diffusion regions may be formed by phosphorus diffusion, sheet resistance of the high-concentration n-type diffusion regions may be 20 to 100 Ω/□, and sheet resistance of the low-concentration n-type diffusion regions may be 30 to 150 Ω/□. Further, the entirely uniform n-type diffusion layer may be formed by phosphorus diffusion, and sheet resistance of the entirely uniform n-type diffusion layer may be 30 to 150 Ω/□.

Further, the p-type diffusion layer and the n-type diffusion layer may be each covered by an insulating film for passivation, and the p-type diffusion layer and the n-type diffusion layer may be each covered by an anti-reflection film. Incidentally, the insulating films for passivation may be located between the p-type diffusion layer and the anti-reflection film and between the n-type diffusion layer and the anti-reflection film.

Further, the light-receiving surface grid electrodes and the busbar electrodes may be each composed of a stack of two first electrode layer and second electrode layer. Here, preferably, the first electrode layer is lower in contact resistance with the silicon single crystal substrate and is higher in adhesive strength with the silicon single crystal substrate than the second electrode layer. The second electrode layer may be lower in specific volume resistivity than the first electrode layer. Further, the light-receiving surface grid electrodes and the busbar electrodes may be formed by screen printing. Incidentally, the light-receiving surface grid electrodes and the busbar electrodes each may be composed of only one layer of the first electrode layer.

According to the present invention in another aspect, there is provided a method of manufacturing a solar battery cell including the steps of: forming, on one surface of an n-type silicon single crystal substrate, a p-type diffusion layer including a plurality of high-concentration p-type diffusion regions and low-concentration p-type diffusion regions each located between the high-concentration p-type diffusion regions; forming, on another surface of the n-type silicon single crystal substrate, an n-type diffusion layer including a plurality of high-concentration n-type diffusion regions and low-concentration n-type diffusion regions each located between the high-concentration n-type diffusion regions; and forming light-receiving surface grid electrodes and busbar electrodes adjacent to the high-concentration p-type diffusion regions and the high-concentration n-type diffusion regions.

Further, according to the present invention, there is provided a method of manufacturing a solar battery cell including the steps of: forming, on one surface of an n-type silicon single crystal substrate, a p-type diffusion layer including a plurality of high-concentration p-type diffusion regions and low-concentration p-type diffusion regions each located between the high-concentration p-type diffusion regions; forming an entirely uniform n-type diffusion layer on another surface of the n-type silicon single crystal substrate; forming light-receiving surface grid electrodes and busbar electrodes adjacent to the high-concentration p-type diffusion regions and the entirely uniform n-type diffusion layer.

In the above-described method of manufacturing the solar battery cell, specific resistance of the silicon single crystal substrate may be 1 to 14 Ω●cm. Further, the p-type diffusion layer and the n-type diffusion layer may be formed simultaneously in such a manner that liquid or solid containing a boron element corresponding to the p-type diffusion layer and liquid or solid containing a phosphorus element corresponding to the n-type diffusion layer are applied or made to adhere on the silicon single crystal substrate in advance, and thereafter heat treatment is performed.

Further, the p-type diffusion layer and the n-type diffusion layer may be formed separately in such a manner that liquid or solid containing a boron element corresponding to the p-type diffusion layer is applied or made to adhere on the silicon single crystal substrate and heat treatment is performed, and next liquid or solid containing a phosphorus element corresponding to the n-type diffusion layer is applied or made to adhere on the silicon single crystal substrate and heat treatment is performed thereafter.

Further, in order to simultaneously form the high-concentration p-type diffusion regions and the high-concentration n-type diffusion regions, the high-concentration p-type diffusion regions and the low-concentration p-type diffusion regions may be formed and the high-concentration n-type diffusion regions and the low-concentration n-type diffusion regions may be formed in such a manner that amounts of liquid or solid containing the boron element applied or made to adhere for the high-concentration p-type diffusion regions and the low-concentration p-type diffusion regions respectively are made different, or liquids (or solid) containing different amounts of the boron element are applied, and amounts of liquid or solid containing the phosphorus element applied or made to adhere for the high-concentration n-type diffusion regions and the low-concentration n-type diffusion regions respectively are made different, or liquids (or solids) containing different amounts of the phosphorus element are applied, and then heat treatment is performed simultaneously.

Further, in order to simultaneously form the high-concentration p-type diffusion regions and the high-concentration n-type diffusion regions, a step of masking surfaces of regions where to form the low-concentration p-type diffusion regions and the low-concentration n-type diffusion regions may be performed by screen printing. Contrarily, in order to simultaneously form the low-concentration p-type diffusion regions and the low-concentration n-type diffusion regions, a step of masking surfaces of regions where to form the high-concentration p-type diffusion regions and the high-concentration n-type diffusion regions may be performed by screen printing.

The formation of the p-type diffusion layer by the boron diffusion and the formation of the n-type diffusion layer by the phosphorus diffusion may be performed separately, and at the time of the boron diffusion, a step of masking the surface, of the silicon single crystal substrate, where to form the p-type diffusion layer may be performed by screen printing; and at the time of the phosphorus diffusion, a step of masking the surface, of the silicon single crystal substrate, where to form the n-type diffusion layer may be performed by screen printing.

Further, as a method for simultaneously forming the high-concentration p-type diffusion regions and the high-concentration n-type diffusion regions, conductive pastes having a self-doping effect may be simultaneously burned to form the diffusion regions. Alternatively, as a method for separately forming the high-concentration p-type diffusion regions and the high-concentration n-type diffusion regions, conductive pastes having a self-doping effect may be separately burned to form the diffusion regions.

Further, as a method for separately forming the high-concentration p-type diffusion regions and the high-concentration n-type diffusion regions, the diffusion layers may be formed by a laser doping method.

Further, a masking agent used for the masking may have hydrofluoric acid resistance and nitric acid resistance and may be peelable by an alkaline solution. A method of forming the masking agent may be a screen printing method.

Further, in the step of forming the n-type diffusion layer, a film formed on a surface of the p-type diffusion layer and removable by a hydrofluoric acid solution may be used as the masking agent. The masking agent used here is preferably a boron silicate glass film, a phosphoric acid glass film, a thermally oxidized film, a boron-phosphorus silicate glass film, a titanium oxide film, a silicon nitride film, or the like removable by a hydrofluoric acid solution. A method of forming the masking agent may be any of heat treatment, thermal CVD, and a plasma CVD method.

Further, in the step of forming the light-receiving surface grid electrodes and the busbar electrodes, a first electrode layer and a second electrode layer may be stacked in two layers to form each of the light-receiving surface grid electrodes and the busbar electrodes. The first electrode layer may be lower in contact resistance with the silicon single crystal substrate and may be higher in adhesive strength with the silicon single crystal substrate than the second electrode layer. The second electrode layer may be lower in specific volume resistivity than the first electrode layer. The light-receiving surface grid electrodes and the busbar electrodes may be formed by screen printing

Incidentally, the light-receiving surface grid electrodes and the busbar electrodes each may be made of one layer of the first electrode layer.

### [Effect of the Invention]

According to the present invention, there is provided a large solar battery cell capable of realizing sufficient conversion efficiency and a method of manufacturing the same.

### [Brief Description of the Drawings]

[FIGs. 1] are explanatory views of steps for manufacturing a solar battery cell.
[FIG. 2] is a schematic explanatory view of the solar battery cell seen from an obliquely upper side.
[FIGs. 3] are explanatory views of a case where boron diffusion and phosphorus diffusion on a substrate are performed simultaneously.
[FIG. 4] is a schematic explanatory view of a solar battery cell where an entirely uniform n-type diffusion layer is formed on a rear surface, seen from an obliquely upper side.
[FIG. 5] is a graph showing results of IV characteristics on a front surface and a rear surface of the solar battery cell.
[FIG. 6] is an explanatory chart showing a measurement result of in-plane distribution of sheet resistance.
[FIG. 7] is a graph showing correlations between conversion efficiencies of the front surface and the rear surface and specific resistance of a substrate.
[FIG. 8] is a graph showing a correlation between Bifaciality of the conversion efficiency of the rear surface and the specific resistance of the substrate.

### [Best Mode for Carrying out the Invention]

Hereinafter, an embodiment of the present invention will be described with reference to the drawings. Note that in the specification and the drawings, constituent elements substantially having the same functions and structures will be denoted by the same reference numerals and symbols and a redundant description thereof will be omitted.

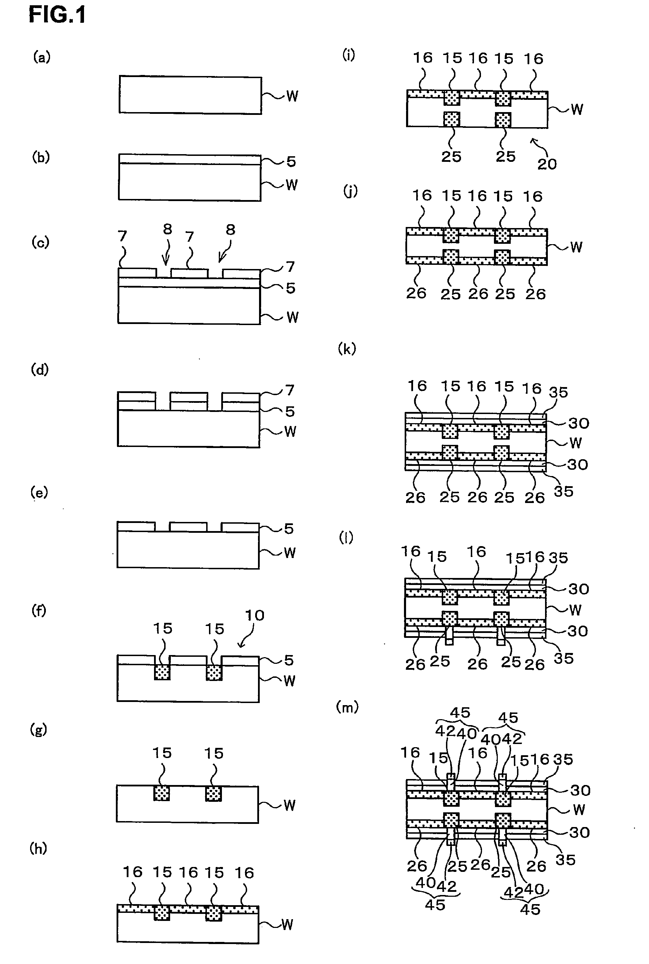

FIGs. 1(a) to (m) are explanatory views of steps for manufacturing a solar battery cell A by using a semiconductor substrate W (hereinafter, also simply referred to as a substrate W) being an n-type silicon single crystal substrate. First, as shown in FIG. 1(a), the n-type semiconductor substrate W being the silicon single crystal substrate manufactured by, for example, a CZ method and having (100) crystal orientation, a 15.6 cm square size, a 100 to 300 µm thickness, and a 1 to 14.0 Ω●cm specific resistance is prepared.

Next the semiconductor substrate W is immersed in a high-concentration (for example, 10 wt%) sodium hydroxide solution, whereby a damage layer is removed. Then, the substrate W is immersed in a low-concentration (for example, 2 wt%) sodium hydroxide solution, whereby a texture structure is formed entirely on a surface of the substrate W. Then, the substrate W is washed.

A reason why the aforesaid texture structure is formed is that it is usually preferable that the solar battery has irregularities on its surface, and the formation of the texture structure reduces reflectance for visible light range, which necessitate reflecting light on a light-receiving surface two times or more if possible. Therefore, the semiconductor substrate W from which the damage layer has been removed is wet-etched by being immersed in a solution in which isopropyl alcohol is added to the sodium hydroxide solution of, for example 2 wt%, whereby a random texture structure is formed on the surface of the semiconductor substrate W. Here, a size of each peak of the texture structure is about 0.3 to 20 µm. Examples of other typical surface irregularity structure is a V groove and a U groove, and these shapes can be formed with the use of a grinder. Further, in order to form the random irregularity structure, acid etching, reactive ion etching, or the like is usable, for instance, instead of the aforesaid method.

Subsequently, as shown in FIG 1(b), oxide films 5 are formed both on a front surface and a rear surface of the substrate W by 980°C heating in an oxygen-containing atmosphere. Incidentally, nitride films may be formed instead of the oxide films 5.

Next, as shown in FIG. 1(c), a resist film 7 in a predetermined pattern is applied to, for example, a 10 to 30 µm thickness on a front surface 10 of the oxide film 5. Then, as shown in FIG. 1(d), with the resist film 7 used as a mask, wet etching using, for example, a 10% HF solution is performed, so that the oxide film 5 on the front surface 10 is etched to a predetermined pattern. At this time, the oxide film 5 is etched to the predetermined pattern formed in the resist film 7.

Next, as shown in FIG. 1(e), the resist films 7 both on the front surface and the rear surface are peeled by an alkaline solution to be removed.

Next, in a diffusion furnace set to 1000°C, boron is diffused on exposed portions of the front surface 10 of the substrate W in an atmosphere containing boron tribromide (BBr₃) gas, with the oxide film 5 etched to the predetermined pattern being used as a mask, as shown in FIG. 1(f). Consequently, a plurality of high-concentration p-type diffusion regions 15 are formed in an island shape on the front surface 10 of the substrate W. Note that sheet resistance of the high-concentration p-type diffusion regions 15 is preferably 20 to 60 Ω/□ (ohm/square). Further, as the method for the boron diffusion, the coating and diffusing method in the atmosphere of the boron tribromide (BBR₃) gas is shown as an example but the method is not limited to this and, for example, boron trichloride (BCl₃) gas or boron oxide (B₂O₅ gas is usable, and a spray method can also be used for the diffusion. Incidentally, for the boron diffusion, adoptable is a method using BN (boron nitride) as a source, or a method using screen printing, ink jetting, spraying, spin coating, or the like.

Next, as shown in FIG. 1(g), the oxide film 5 on the front surface 10 is removed by wet etching using, for example, a 10% HF solution. Then, in a diffusion furnace set to 930°C, boron is diffused on the whole front surface 10 of the substrate W in an atmosphere containing boron tribromide (BBr₃) gas. Consequently, as shown in FIG. 1(h), low-concentration p-type diffusion regions 16 are formed each between the plural high-concentration p-type diffusion regions 15 on the front surface 10 of the substrate W. Here, boron silicate glass films (not shown) are also formed both on the front surface and the rear surface of the substrate W. Note that sheet resistance of the low-concentration p-type diffusion regions 16 is preferably 30 to 150 Ω/□.

Subsequently, a masking agent is printed on the front surface 10 by a screen printing method, followed by drying in a 180°C hot-air drying furnace. By this printing of the masking agent, the boron silicate glass film (not shown) formed on the front surface 10 of the substrate W is protected. As the masking agent, it is preferable to use a material having hydrofluoric acid resistance and nitric acid resistance and peelable by an alkaline solution.

Next, the substrate W on whose front surface 10 the masking agent is printed (after the drying) is immersed in, for example, a fluoro nitric acid solution or a hydrofluoric acid solution, whereby the boron silicate glass film (not shown) formed on the other surface of the substrate W on which the masking agent is not printed (hereinafter, referred to as a rear surface 20) and high-concentration p-type diffusion regions formed by out-diffusion are removed. Then, the masking agent 18 is removed with the use of, for example, a sodium hydroxide solution, and the substrate W is washed and dried.

Next, in an electric diffusion furnace set to 870°C, phosphorus is diffused on exposed portions of the rear surface 20 of the substrate W in an atmosphere containing phosphorus oxychloride (POCl₃) gas, with the oxide film 5 formed by the same method as that on the front surface 10 and etched to a predetermined pattern being used as a mask. In this phosphorus diffusion on the rear surface 20, the oxide film 5 and the resist film 7 are also formed into a pattern as in the boron diffusion on the front surface 10, and diffusion regions are formed, but methods for this formation of the oxide film 5 and the resist film 7 and the removal of the oxide film 5 and the resist film 7 after the phosphorus diffusion are the same as those described above in FIGs. (b) to (f), and therefore, a description thereof will be omitted here.

Consequently, a plurality of high-concentration n-type diffusion regions 25 are formed in an island shape on the rear surface 20 of the substrate W as shown in FIG. 1(i). Here, sheet resistance of the high-concentration n-type diffusion regions 25 is preferably 20 to 60 Ω/□ (ohm/square). Further, the phosphorus diffusion is performed by an ink-jet method, spraying, spin coating, a laser doping method, or the like.

Then, in an electric diffusion furnace set to 830°C, phosphorus is diffused on the whole rear surface 20 of the substrate W in an atmosphere containing phosphorus oxychloride (POCl₃) gas. Consequently, as shown in FIG. 1(j), low-concentration n-type diffusion regions 26 are formed each between the plural high-concentration n-type diffusion regions 25 on the rear surface 20 of the substrate W. At this time, phosphoric acid glass films (not shown) are formed both on the front surface and the rear surface of the substrate W. Note that sheet resistance of the low-concentration n-type diffusion regions 26 is preferably 30 to 150 Ω/□.

Next, PN junction in a peripheral portion of the substrate W is separated by a plasma etcher, and the boron silicate glass films (not shown) and the phosphoric acid glass films (not shown) which are formed on the front surface 10 and the rear surface 20 of the substrate W in the above-described steps are removed by etching using a hydrofluoric acid solution. Thereafter, anti-reflection films 35 being, for example, nitride films (SiNx films) are formed on the whole front surface 10 and rear surface 20 by a plasma CVD apparatus. Here, examples of other kinds of the anti-reflection films 35 are titanium dioxide films, zinc oxide films, tin oxide films, and the like, which can be used as a substitute. Further, it is described that the direct plasma CVD method by the plasma CVD apparatus is used for the formation of the anti-reflection films 35, but a remote plasma CVD method, a coating method, a vacuum vapor deposition method, or the like may be used, for instance. However, from an economic point of view, it is the most suitable to form the nitride films by the plasma CVD method. Further, when films such as, for example, magnesium difluoride films whose refractive index is 1 to 2 are formed on the anti-reflection films 35 in order to make the total reflectance the smallest, a reduction in reflectance is promoted and density of generated current becomes high. Further, insulating films for passivation may be formed between the substrate W and the anti-reflection films 35.

Subsequently, as shown in FIG. 1(l), first electrode layers 40 made of a conductive paste containing, for example, Ag are printed in a predetermined pattern on surfaces (lower side in the drawing) of the high-concentration n-type diffusion regions 25 on the rear surface 20 of the substrate W by using a screen printer, followed by drying. Then, second electrode layers 42 made of a conductive paste containing, for example, Ag are printed by screen printing on surfaces (lower side in the drawing) of the first electrode layers 40 formed on the high-concentration n-type diffusion regions 25, followed by drying. Stacks each composed of the first electrode layer 40 and the second electrode layer 42 serve as light-receiving surface grid electrodes and busbar electrodes (they will be also collectively referred to as electrodes 45). The first electrode layers 40 printed on the surfaces of the high-concentration n-type diffusion regions 25 each may be made of a conductive paste containing a phosphorus element and having a self-doping effect in a burning step. Further, in this embodiment, the electrodes 45 are each composed of the first electrode layer 40 and the second electrode layer, but the electrodes 45 may be each made of a single-layer conductive paste.

Next, as shown in FIG. 1(m), first electrode layers 40 made of a conductive paste containing, for example, Ag are printed in a predetermined pattern on surfaces (upper side in the drawing) of the high-concentration p-type diffusion regions 15 as in the above-described case shown in FIG. 1(l), followed by drying. Then, second electrode layers 42 made of a conductive paste containing, for example, Ag are printed by screen printing on surfaces (upper side in the drawing) of the first electrode layers 40 formed on the high-concentration p-type diffusion regions 15, followed by drying. Incidentally, the first electrode layers 40 printed on the surfaces of the high-concentration p-type diffusion regions 15 may be each made of a conductive paste containing a boron element and having a self-doping effect in the burning step. Further, in this embodiment, the electrodes 45 are each composed of the first electrode layer 40 and the second electrode layer, but the electrodes 45 may be each made of a single-layer conductive paste.

Here, the first electrode layers 40 are preferably made of a material lower in contact resistance with the silicon single crystal substrate (semiconductor substrate W) and higher in adhesive strength with the silicon single crystal substrate (semiconductor substrate W) than the second electrode layers 42. Further, the second electrode layers 42 are preferably lower in specific volume resistivity and more excellent in conductivity than the first electrode layers 40. A purpose of the electrodes 45 are to efficiently take out electrons generated in the substrate W. For this purpose, it is desirable that the electrodes 45 are made high and contact resistance of interfaces where the electrodes 45 and the substrate W are in contact with each other is low, and specific volume resistivity of the electrodes 45 is low. For these purposes, the electrodes 45 are each made as a two-layered structure composed of the first electrode 40 and the second electrode layer 42 so as to become high, the first electrode layers 40 disposed at positions where they are in contact with the substrate W are made low in contact resistance with the substrate W, and the second electrode layers 42, which are not in contact with the substrate W, are made lower in specific volume resistivity than the first electrode layers 40.

Then, the substrate W in which the electrodes 45 are formed on the high-concentration p-type diffusion regions on the front surface 10 and on the high-concentration n-type diffusion regions on the rear surface 20 is burned, whereby a solar battery cell A is fabricated.

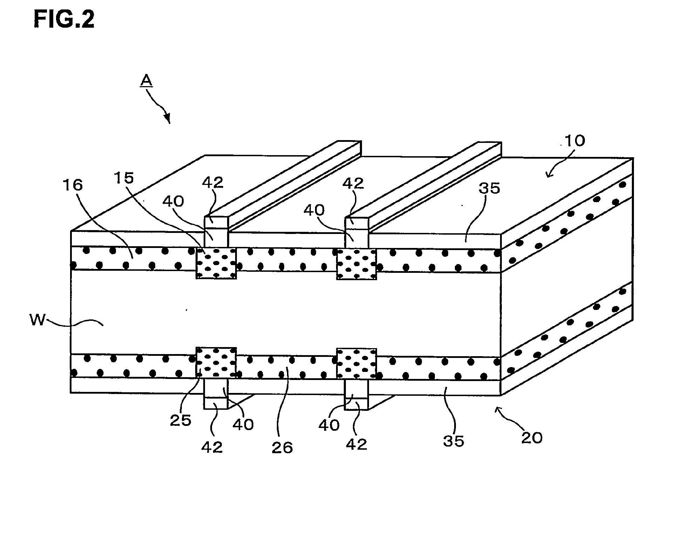

FIG. 2 is a schematic explanatory view of the solar battery cell A seen from an obliquely upper side. Note that FIG. 2 shows part of the solar battery cell A in an enlarged manner, and also schematically shows a cross section of the solar battery cell A. As shown in FIG. 2, the high-concentration p-type diffusion regions are disposed on the front surface 10 of the semiconductor substrate W, the electrodes 45 each composed of the two layers (the first electrode layer 40, the second electrode layer 42) are formed directly on upper surfaces of the high-concentration p-type diffusion regions, the high-concentration n-type diffusion regions are disposed on the rear surface 20, and the electrodes 44 each composed of the two layers are formed directly on lower surfaces of the high-concentration n-type diffusion regions in the above-described steps, so that the solar battery cell is fabricated in which in-plane uniformity of the sheet resistance is sufficiently ensured and power generation capacities of the front surface and the rear surface of the solar battery cell A are 18% or more in terms of conversion efficiency.

Further, the solar battery cell A with a large 15.6 cm square size in which a ratio of conversion efficiency of the rear surface to that of the front surface of the solar battery cell A (Bifaciality) is 93% or more is fabricated.

In addition, since the electrodes 45 each have the structure composed of the stacked first electrode layer 40 and second electrode layer 42, the solar battery cell A capable of efficiently taking out electrons generated in the substrate W is fabricated.

Hitherto, an example of the embodiment of the present invention is described, but the present invention is not limited to the shown embodiment, and it is obvious that those skilled in the art could think of various kinds of changed examples and modified examples within a scope of the ideas described in the claims, and it is naturally understood that they also belong to the technical scope of the present invention.

In the above-described embodiment, the diffusion is performed through the steps of forming the high-concentration diffusion regions (both p-type and n-type) and thereafter forming the low-concentration diffusion regions (p-type and n-type), but the formation method of the diffusion layers is not necessarily limited to this method. For example, a method of forming the high-concentration diffusion regions (p-type, n-type) and the low-concentration diffusion regions (p-type, n-type) on the light-receiving surfaces of the semiconductor substrate W may be a method in which, after the low-concentration diffusion regions are formed on the whole light-receiving surfaces of the semiconductor substrate W, additional heat treatment is performed, with the phosphoric acid glass films (or boron silicate glass films) being left at portions where to form the high-concentration diffusion regions, whereby the high-concentration diffusion regions are formed.

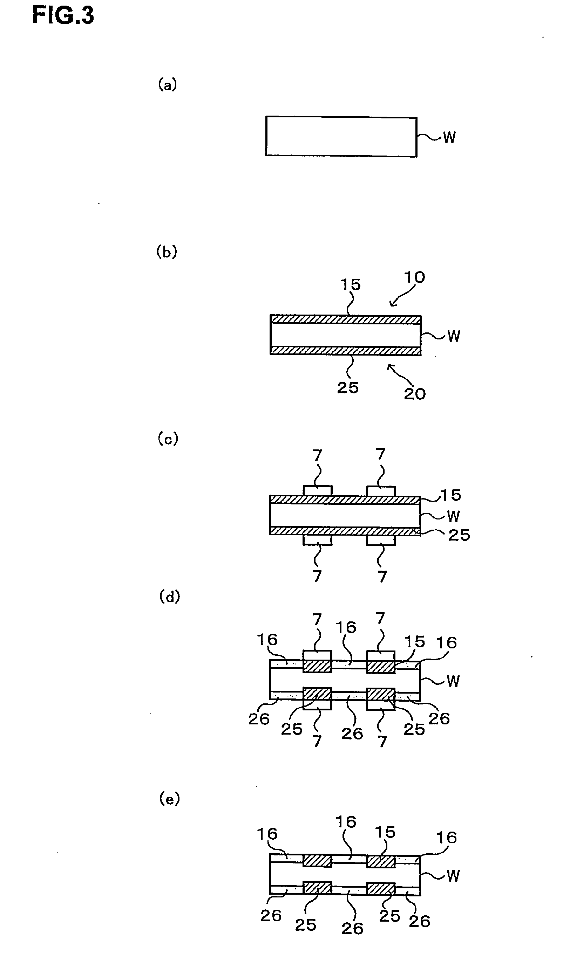

Another possible method for the boron diffusion and the phosphorus diffusion may be a method in which liquids or solids containing the respective elements are applied on the surfaces (front surface, rear surface) of the substrate W in advance and thereafter perform heat treatment, thereby simultaneously forming the high-concentration p-type diffusion regions and the high-concentration n-type diffusion regions. Hereinafter, a case where the boron diffusion and the phosphorous diffusion on the substrate W are simultaneously performed will be described with reference to FIGs. 3. Since the steps except steps relating to the boron diffusion and the phosphorus diffusion are performed by the same methods as those in the above-described steps in FIGs. 1, only explanatory views of the steps of performing the boron diffusion and the phosphorus diffusion are illustrated in FIGs. 3.

As shown in FIGs. 3(a), (b), liquid or solid containing a boron element is applied or made to adhere on the front surface 10 of the substrate W, followed by drying, and liquid or solid containing a phosphorus element is applied or made to adhere on the rear surface 20 of the substrate W, followed by drying, and thereafter heat treatment is performed in a furnace set to, for example, 90°C to form the high-concentration p-type diffusion region 15 on the whole front surface 10 and the high-concentration n-type diffusion region 25 on the whole rear surface 20.

Next, as shown in FIG. 3(c), the front surface 10 on which the high-concentration p-type diffusion region 15 is formed is coated with a resist film 7 in a predetermined pattern with, for example, 10 to 30 µm thickness, followed by drying in a 180°C hot-air drying furnace. Next, the high-concentration n-type diffusion region 25 is coated with a resist film 7 in a predetermined pattern with, for example, a 10 to 30 µm thickness, followed by drying in a 180°C hot-air drying furnace. It is preferable to use a material having hydrofluoric acid resistance and nitric acid resistance and peelable by an alkaline solution.

Next, the substrate W on which the resist films 7 are printed on the front surface 10 and the rear surface 20 is immersed in, for example, a fluoro nitric acid solution, and by etching the high-concentration p-type diffusion region 15 and the high-concentration n-type diffusion region 25 on portions, of the surfaces of the substrate W, where the resist films 7 are not printed, the low-concentration p-type diffusion regions 16 and the low-concentration n-type diffusion regions 26 are formed as shown in FIG. 3(d).

Next, the resist films are peeled by the alkaline solution, so that the resist films 7 both on the front surface and the rear surface are removed, and as shown in FIG. 3(e), the high-concentration p-type diffusion regions and the high-concentration n-type diffusion regions are simultaneously formed.

Further, in the above-described embodiment, the case where the high-concentration diffusion regions are formed both on the front surface 10 and the rear surface 20 of the substrate W is described, but the present invention is not limited to this. For example, it is also conceivable to form an entirely uniform n-type diffusion layer on the rear surface 20 of the substrate W and form the high-concentration diffusion regions and the low concentration diffusion regions only on the front surface 20 of the substrate W.

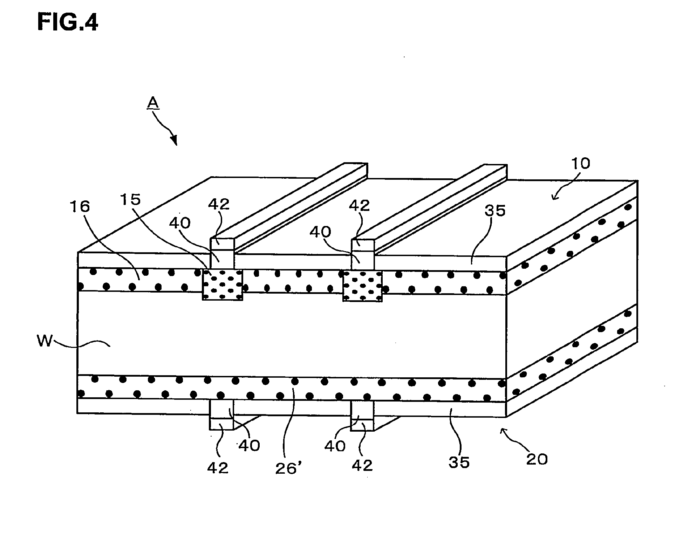

FIG. 4 is an explanatory view of a solar battery cell A where an entirely uniform n-type diffusion layer 26' is formed on a rear surface 20 of a substrate W. Note that the solar battery cell A shown in FIG. 4 has the same structure as that described in the above-described embodiment except the structure of the n-type diffusion layer 26' on the rear surface 20.

Forming the entirely uniform n-type diffusion layer 26' on the rear surface 20 as shown in FIG. 4 makes it possible to realize a great cost reduction because the resist printing step and the resist removing step are reduced. Moreover, owing to a reduction in the heat treatment step, a thermal damage to the substrate W can be reduced.

### [Examples]

### (Example 1)

As an example 1, an n-type semiconductor substrate being a silicon single crystal substrate fabricated by a CZ method and having (100) crystal orientation, a 15.6 cm square size, a 200 µm thickness, and a 2.8 Ω●cm specific resistance was prepared, and the semiconductor substrate was immersed in a 10 wt% sodium hydroxide solution, whereby a damage layer was removed. Then, the substrate was immersed in a 2 wt% sodium hydroxide solution, whereby a texture structure was formed on the whole surface of the substrate. Then, the substrate was washed.

Next, 1000°C dry oxidation was performed to form oxide films on the whole light-receiving surfaces. Thereafter, in order to mask portions where to form low-concentration p-type diffusion regions, a resist agent was printed by a screen printer, followed by drying in a 180° hot-air drying furnace. After the drying, the oxide film on high-concentration p-type diffusion portions was removed by the immersion in a 10 wt% hydrofluoric acid solution, and thereafter the resist agent was removed by a 2 wt% sodium hydroxide solution, and the substrate was washed and dried. Thereafter, boron diffusion was performed on the substrate by BBr3 gas diffusion, whereby the high-concentration p-type diffusion regions were formed.

Next, the substrate was immersed in a 10 wt% hydrofluoric acid solution, whereby the oxide film on the low-concentration p-type diffusion region portions were removed, and after drying, boron diffusion was performed again on the substrate by the BBr3 gas diffusion in a 930°C electric diffusion furnace, whereby the low-concentration p-type diffusion regions were formed.

Next, on the whole surface on which the high-concentration p-type diffusion regions and the low-concentration p-type diffusion regions were formed, a resist agent was printed by a screen printer, followed by drying in a 180°C hot-air drying furnace. After the drying, a boron silicate glass film on the surface where to form high-concentration n-type diffusion regions and low-concentration n-type diffusion regions and p-type diffusion regions were removed by the immersion in a fluoro nitric acid solution. Then, the resist agent was removed in a sodium hydroxide solution and the substrate was washed and dried.

Next, 1000°C dry oxidation was performed to form oxide films on the whole light-receiving surfaces. Thereafter, in order to mask portions where to form the low-concentration n-type diffusion regions, a resist agent was printed by a screen printer, followed by drying in a 180°C hot-air drying furnace. After the drying, the oxide film on the high-concentration n-type diffusion portions was removed by the immersion in a 10 wt% hydrofluoric acid solution, and thereafter, the resist agent was removed by a 2 wt% sodium hydroxide solution, and the substrate was washed and dried. Thereafter, the diffusion on the substrate was performed in an electric diffusion furnace having an atmosphere containing phosphorus oxychloride, whereby the high-concentration n-type diffusion regions were formed.

Next, the substrate was immersed in a 10 wt% hydrofluoric acid solution, whereby the oxide film on the low-concentration n-type diffusion region portions was removed, and after drying, the diffusion on the substrate was performed again in an 830°C electric diffusion furnace having an atmosphere containing phosphorus oxychloride, whereby the low-concentration n-type diffusion regions were formed.

Next, PN junction in a peripheral portion of the substrate was separated by a plasma etcher, and subsequently, after phosphoric acid glass films, boron silicate glass films, or boron-phosphorus silicate glass films formed on the surfaces of the substrate were removed in a hydrofluoric acid solution, insulating films for passivation were formed, and anti-reflection films were formed by the deposition of nitride films on the both surfaces of the substrate by a plasma CVD apparatus.

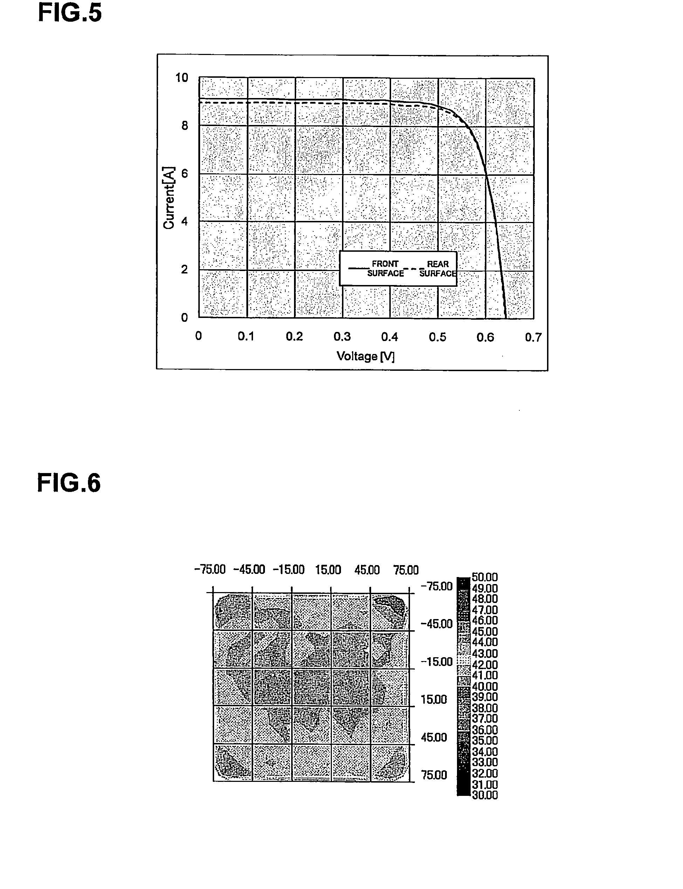

Next, by using a screen printer, grid Ag electrodes and busbar electrodes are printed on the high-concentration n-type diffusion regions on the rear surface, followed by drying. On upper sides of the grid Ag electrodes and the busbar electrodes, the same electrode patterns were printed and dried, whereby two-layered electrodes were formed. Further, by using the screen printer, grid Ag electrodes and busbar electrodes were printed on the high-concentration p-type diffusion regions on the front surface and dried. On upper sides of the grid Ag electrodes and the busbar electrodes, the same electrode patterns were printed and dried, whereby two-layered electrodes were formed. Thereafter, burning was performed to form grid electrodes and busbar electrodes, whereby a solar battery cell was fabricated. Results of IV characteristics of the front surface and the rear surface of the solar battery cell are shown in Table 1 and FIG. 5.

**[Table 1]**

| | Eff (%) | Voc (mV) | Isc (A) | FF (%) |
|---|---|---|---|---|
| FRONT SURFACE | 19.27 | 642 | 9.14 | 78.4 |
| REAR SURFACE | 19.07 | 642 | 8.95 | 79.2 |

Further, FIG. 6 is an explanatory chart showing the result of measurement of in-plane distribution of sheet resistance in a 15.6 cm square substrate after the boron diffusion is performed. One problem in the upsizing of the substrate is difficulty in realizing in-plane uniformity of the boron diffusion. It has been found out that the present invention has solved the problem by improving in-plane uniformity in the boron diffusion.

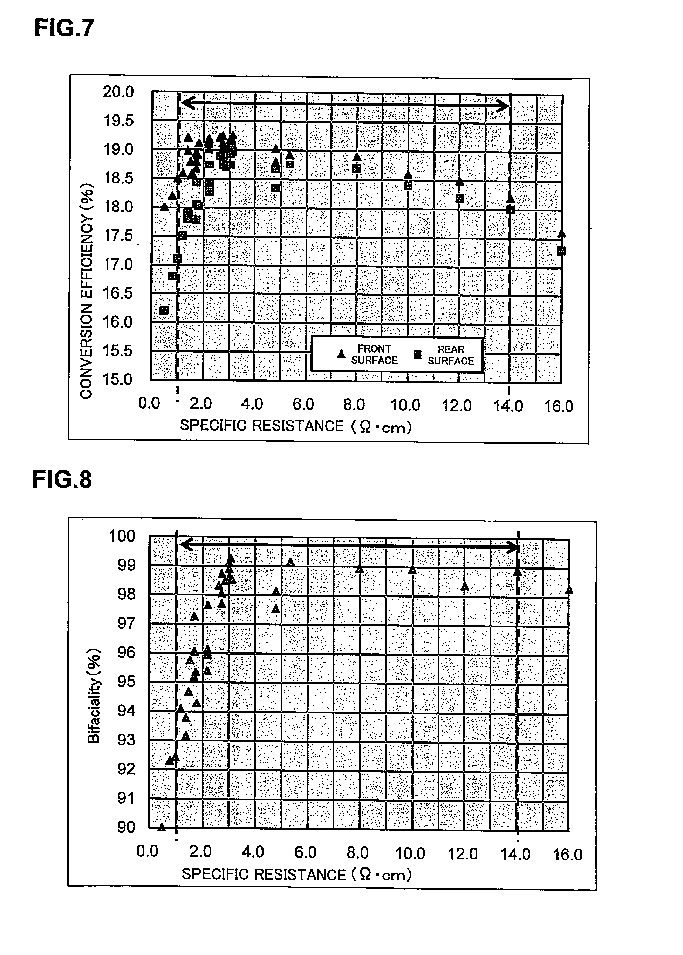

Further, the results of changes in conversion efficiency (Eff) when the specific resistance of the substrate is changed are shown in FIG. 7. The result of a change in a ratio of rear surface conversion efficiency to front surface conversion efficiency (written as Bifaciality in the graph) when the specific resistance of the substrate is changed is shown in FIG. 8.

As shown in FIG. 7 and FIG. 8, it has been found out that, when the specific resistance is in a 1 to 14 Ω●m range and the conversion efficiency of the front surface is 18% or more, Bifaciality can be maintained at 93% or more.

### [Industrial Applicability]

The present invention is applicable to a solar battery cell and a method of manufacturing the same.

### [Explanation of Codes]

- 5: oxide film
- 7: resist film
- 10: front surface
- 15: high-concentration p-type diffusion region
- 16: low-concentration p-type diffusion region
- 20: rear surface
- 25: high-concentration n-type diffusion region
- 26: low-concentration n-type diffusion region
- 26': entirely uniform n-type diffusion layer
- 30: oxide film
- 35: anti-reflection film
- 40: first electrode layer
- 42: second electrode layer
- 45: electrode
- A: solar battery cell
- W: semiconductor substrate

## Claims

**1.** A solar battery cell comprising:
an n-type silicon single crystal substrate;
a p-type diffusion layer formed on one surface of the silicon single crystal substrate;
an n-type diffusion layer formed on another surface of the silicon single crystal substrate;
one light-receiving surface grid electrode or more and one busbar electrode or more which are formed on part of the p-type diffusion layer;
one light-receiving surface grid electrode or more and one busbar electrode or more which are formed on part of the n-type diffusion layer,
wherein a plurality of high-concentration p-type diffusion regions and low-concentration p-type diffusion regions each located between the high-concentration p-type diffusion regions are formed in the p-type diffusion layer,
wherein a plurality of high-concentration n-type diffusion regions and low-concentration n-type diffusion regions each located between the high-concentration n-type diffusion regions are formed in the n-type diffusion layer,
wherein the light-receiving surface grid electrodes and the busbar electrodes are formed adjacently to the high-concentration p-type diffusion regions and the high-concentration n-type diffusion regions,
wherein surface power generation capacity is 18% or more in terms of conversion efficiency, and
wherein conversion efficiency of the other surface on which the n-type diffusion layer is formed is equal to or higher than 93% of conversion efficiency of the one surface on which the p-type diffusion layer is formed.

**2.** A solar battery cell comprising:
an n-type silicon single crystal substrate;
a p-type diffusion layer formed on one surface of the silicon single crystal substrate;
an entirely uniform n-type diffusion layer formed on another surface of the silicon single crystal substrate;
one light-receiving surface grid electrode or more and one busbar electrode or more which are formed on part of the p-type diffusion layer;
one light-receiving surface grid electrode or more and one busbar electrode or more which are formed on part of the n-type diffusion layer,
wherein a plurality of high-concentration p-type diffusion regions and low-concentration p-type diffusion regions each located between the high-concentration p-type diffusion regions are formed in the p-type diffusion layer,
wherein the light-receiving surface grid electrodes and the busbar electrodes are formed adjacently to the high-concentration p-type diffusion regions and the entirely uniform n-type diffusion layer,
wherein surface power generation capacity is 18% or more in terms of conversion efficiency, and
wherein conversion efficiency of the other surface on which the n-type diffusion layer is formed is equal to or higher than 93% of conversion efficiency of the one surface on which the p-type diffusion layer is formed.

**3.** The solar battery cell according to claim 1 or 2, wherein specific resistance of the silicon single crystal substrate is 1 to 14 Ω●cm.

**4.** The solar battery cell according to claim 3, wherein the high-concentration p-type diffusion regions and the low-concentration p-type diffusion regions are formed by boron diffusion, sheet resistance of the high-concentration p-type diffusion regions is 20 to 100 Ω/□, and sheet resistance of the low-concentration p-type diffusion regions is 30 to 150 Ω/□.

**5.** The solar battery cell according to claim 1, wherein the high-concentration n-type diffusion regions and the low-concentration n-type diffusion regions are formed by phosphorus diffusion, sheet resistance of the high-concentration n-type diffusion regions is 20 to 100 Ω/□, and sheet resistance of the low-concentration n-type diffusion regions is 30 to 150 Ω/□.

**6.** The solar battery cell according to claim 2, wherein the entirely uniform n-type diffusion layer is formed by phosphorus diffusion, and sheet resistance of the entirely uniform n-type diffusion layer is 30 to 150 Ω/□.

**7.** The solar battery cell according to claim 1 or 2, wherein the p-type diffusion layer and the n-type diffusion layer are each covered by an insulating film for passivation.

**8.** The solar battery cell according to claim 1 or 2, wherein the p-type diffusion layer and the n-type diffusion layer are each covered by an anti-reflection film.

**9.** The solar battery cell according to claim 1 or 2, wherein the light-receiving surface grid electrodes and the busbar electrodes are each composed of a stack of two first electrode layer and second electrode layer.

**10.** The solar battery cell according to claim 9, wherein the first electrode layer is lower in contact resistance with the silicon single crystal substrate and is higher in adhesive strength with the silicon single crystal substrate than the second electrode layer.

**11.** The solar battery cell according to claim 9, wherein the second electrode layer is lower in specific volume resistivity than the first electrode layer.

**12.** The solar battery cell according to claim 1 or 2, wherein the light-receiving surface grid electrodes and the busbar electrodes are formed by screen printing.

**13.** A method of manufacturing a solar battery cell comprising the steps of:
forming, on one surface of an n-type silicon single crystal substrate, a p-type diffusion layer including a plurality of high-concentration p-type diffusion regions and low-concentration p-type diffusion regions each located between the high-concentration p-type diffusion regions;
forming, on another surface of the n-type silicon single crystal substrate, an n-type diffusion layer including a plurality of high-concentration n-type diffusion regions and low-concentration n-type diffusion regions each located between the high-concentration n-type diffusion regions; and
forming light-receiving surface grid electrodes and busbar electrodes adjacent to the high-concentration p-type diffusion regions and the high-concentration n-type diffusion regions.

**14.** A method of manufacturing a solar battery cell comprising the steps of:
forming, on one surface of an n-type silicon single crystal substrate, a p-type diffusion layer including a plurality of high-concentration p-type diffusion regions and low-concentration p-type diffusion regions each located between the high-concentration p-type diffusion regions;
forming an entirely uniform n-type diffusion layer on another surface of the n-type silicon single crystal substrate;
forming light-receiving surface grid electrodes and busbar electrodes adjacent to the high-concentration p-type diffusion regions and the entirely uniform n-type diffusion layer.

**15.** The method of manufacturing the solar battery cell according to claim 13 or 14, wherein specific resistance of the silicon single crystal substrate is 1 to 14 Ω●cm.

**16.** The method of manufacturing the solar battery cell according to claim 13 or 14, wherein the p-type diffusion layer and the n-type diffusion layer are formed simultaneously in such a manner that liquid or solid containing a boron element corresponding to the p-type diffusion layer and liquid or solid containing a phosphorus element corresponding to the n-type diffusion layer are applied or made to adhere on the silicon single crystal substrate in advance, and thereafter heat treatment is performed.

**17.** The method of manufacturing the solar battery cell according to claim 13 or 14,
wherein the formation of the p-type diffusion layer by boron diffusion and the formation of the n-type diffusion layer by phosphorus diffusion are performed separately,
wherein at the time of the boron diffusion, a step of masking the surface, of the silicon single crystal substrate, where to form the p-type diffusion layer is performed by screen printing; and
wherein at the time of the phosphorus diffusion, a step of masking the surface, of the silicon single crystal substrate, where to form the n-type diffusion layer is performed by screen printing.

**18.** The method of manufacturing the solar battery cell according to claim 17, wherein a masking agent used for the masking has hydrofluoric acid resistance and nitric acid resistance and is peelable by an alkaline solution.

**19.** The method of manufacturing the solar battery cell according to claim 13 or 14, wherein, in the step of forming the n-type diffusion layer, a film formed on a surface of the p-type diffusion layer and removable by a hydrofluoric acid solution is used as a barrier film.

**20.** The method of manufacturing the solar battery cell according to claim 13 or 14, wherein, in the step of forming the light-receiving surface grid electrodes and the busbar electrodes, a first electrode layer and a second electrode layer are stacked in two layers to form each of the light-receiving surface grid electrodes and the busbar electrodes.

**21.** The method of manufacturing the solar battery cell according to claim 20, wherein the first electrode layer is lower in contact resistance with the silicon single crystal substrate and is higher in adhesive strength with the silicon single crystal substrate than the second electrode layer.

**22.** The method of manufacturing the solar battery cell according to claim 20, wherein the second electrode layer is lower in specific volume resistivity than the first electrode layer.

**23.** The method of manufacturing the solar battery cell according to claim 13 or 14, wherein the light-receiving surface grid electrodes and the busbar electrodes are formed by screen printing.
